# EUROPEAN PATENT APPLICATION

(11) **EP 2 642 532 A1**
(43) Date of publication of application: **25.09.2013**
(21) Application number: 12848326.0
(22) Date of filing: 30.08.2012
(51) Int. Cl.: H01L 33/00, H01L 33/64

(54) **PROCESS FOR MANUFACTURING HEAT SINK STRUCTURE FOR HIGH-POWER LED**

(30) Priority: 09.11.2011 CN 201110351480
(71) Applicant: Dongguan Kingsun Optoelectronic Co., Ltd, Guangdong 523565 (CN)
(72) Inventor: BI, Xiaofeng, Dongguan Guangdong 523565 (CN)
(74) Representative: Michalski Hüttermann & Partner Patentanwälte
(86) International application number: PCT/CN2012/080773
(87) International publication number: WO 2013/067842

(57) **Abstract**

A manufacturing process of a high-power LED radiating structure includes steps of: (1) preparing parts or material such as a PCB board (4), a heat conducting plate (6) and a heat dissipating plate (9); (2) providing a first locating hole and a first fixing hole passing through the PCB board, welding a copper plate layer on one side of the PCB board, and welding an electrode weld pad on the other side of the PCB board, and then applying soldering paste on the surface of the copper plate layer; (3) providing a second locating hole and a second fixing hole passing through the heat conducting plate; (4) inserting a fixing pole into the first and second fixing holes to fixedly connect the PCB board and the heat conducting plate together; (5) inserting the heat conducting pole into the first and second locating holes; (6) proving the heat conducting plate and the PCB board resulted from step (5) on a stamping equipment, and adjusting the length of the protruding end of the heat conducting pole. The inventive process is simple, and the manufactured dissipating structure is advantageous for a simple construction and good heat conducting and dissipating effects.

## Description

### Field of the Invention

The invention relates to the field of heat dissipating equipments, and more particularly, to a manufacturing process of a high-power Light-Emitting Diode (LED) radiating structure (i.e. heat dissipating structure).

### Background of the Invention

Because of its characteristics such as a theoretically long service life, low energy consumption and environment-friendly, an LED has been widely used in various fields including indication, indoor and outdoor illumination, etc. As well known, the most critical factor affecting the service life of an LED, particularly a high-power LED, is LED heat dissipating. The existing high-power LED heat dissipating structure is manufactured by sequentially connecting parts including a heat sink, an aluminum substrate, thermally conductive silicone, heat dissipating plate, etc., and the LED is connected to the aluminum substrate via the heat sink. Although such a manufacture process is simple, the resultant heat dissipating structure as manufactured is defective and disadvantageous for poor heat conduction and dissipation performance mainly caused by structural arrangement of the aluminum substrate, thereby greatly influencing the application field and scope of the LED. Commonly, the aluminum substrate is made by stacking a protecting oil layer, a copper foil layer, an electrically insulating layer and an aluminum plate layer in sequence, among which the electrically insulating layer leads to a negative effect of heat insulation despite of its good and effective role in electrical insulation, so that the heat generated by the LED cannot be promptly dissipated, thereby greatly influencing the service life of the LED. Thus, it is necessary to improve the existing manufacturing process to realize differentiation in heat dissipating structures, and resolve the LED heat dissipating problem effectively.

### Summary of the Invention

In view of the defects and disadvantages in the prior art, an objective of the invention is to provide a manufacturing process of a high-power LED radiating structure, which is simple and of a high production efficiency, and the heat dissipating structure manufactured by the process is advantageous for a simple and compact structure, a good heat dissipating effect, etc.

The present invention employs the following technical solution, in order to achieve the above mentioned objective.

The manufacturing process of a high-power LED radiating structure of the invention includes steps of:

(1) preparing a Printed Circuit Board (PCB) board, a heat conducting plate and a heat dissipating plate;

(2) providing, in the PCB board, a first locating hole and a first fixing hole that pass through both sides of the PCB board, welding a copper plate layer on one side of the PCB board, and welding an electrode weld pad on the other side of the PCB board, and then applying soldering paste on the surface of the copper plate layer;

(3) providing, in the heat conducting plate, a second locating hole and a second fixing hole that pass though both sides of the heat conducting plate;

(4) stacking a side of the heat conducting plate and a side of the PCB board on which the copper plate layer is provided, wherein the first locating hole and the second locating hole map with each other, and the first fixing hole and the second fixing hole map with each other; and inserting a fixing pole into the first fixing hole and the second fixing hole to fixedly connect the PCB board and the heat conducting plate together;

(5) inserting a heat conducting pole into the first locating hole and the second locating hole, wherein one end of the heat conducting pole protrudes out of the side of the PCB board, and the length of the protruding end of the heat conducting pole is larger than the thickness of the electrode weld pad;

(6) placing the heat conducting plate and the PCB board, into which the heat conducting pole is inserted in Step (5), on a stamping equipment, which stamps on the upper end face of the heat conducting pole, to achieve the length of the protruding end of the heat conducting pole by adjusting a sliding block of the stamping equipment, such that the upper end face of the heat conducting pole is at the same plane with the upper surface of the electrode weld pad; and

(7) engaging the upper side of the heat dissipating plate with the other side of the heat conducting plate.

In Step (5), several heat dissipating fins are provided on the lower side of the heat dissipating plate.

In Step (4), after the PCB board and the heat conducting plate are fixedly connected together, the heat conducting plate and the copper plate layer are welded together via reflow soldering;

In Step (4), both of the first fixing hole and the second fixing hole are provided as through holes, and the fixing pole is a rivet.

In Step (4), both of the first fixing hole and the second fixing hole are provided as threaded holes, and the fixing pole is a screw.

In Step (1), the heat conducting pole is threadedly connected with the first locating hole and the second locating hole.

In Step (1), the heat conducting plate is made from copper.

In Step (1), the heat dissipating plate is made from aluminum or copper.

In Step (1), the heat conducting pole is made from copper.

The above mentioned manufacturing process of the invention is beneficial as follows: since the upper surface of the electrode weld pad and the upper end face of the heat conducting pole are arranged in the same plane with the inventive process, when the bottom side of the LED substrate rests against on the electrode weld pad and the heat conducting pole, the bottom side of the LED substrate may be sufficiently in contact and welded with the upper end face of the heat conducting pole without affecting the electric connection between the bottom side of the LED substrate and the electrode weld pad, so as to effectively increase the contact area between the heat conductive part at the bottom side of the LED substrate and the upper end face of the heat conducting pole. As such, with the heat dissipating structure manufactured by the process of the invention, the heat generated by the LED can be quickly dissipated via the heat conducting pole and the heat conducting plate, thereby greatly improved the heat dissipating function of such structure.

### Brief Description of the Drawings

FIG. 1 schematically shows an overall structural section view of a heat dissipating structure manufactured in the invention; and

FIG. 2 schematically shows an exploded structural view of the heat dissipating structure manufactured in the invention.

### Reference numeral list:

| | | | |
|---|---|---|---|
| 1: LED; | 2: substrate; | 3: electrode weld pad; | 4: PCB board |
| 5: copper plate layer; | 6: heat conducting plate; | 7: heat conducting pole; | |
| 8: fixing pole; | 9: heat dissipating plate; | 10: heat dissipating fins; | |
| 41: first locating hole; | 42: first fixing hole; | 61: second locating hole; | |
| 62: second fixing hole; | | | |

### Detailed Description of the Embodiments

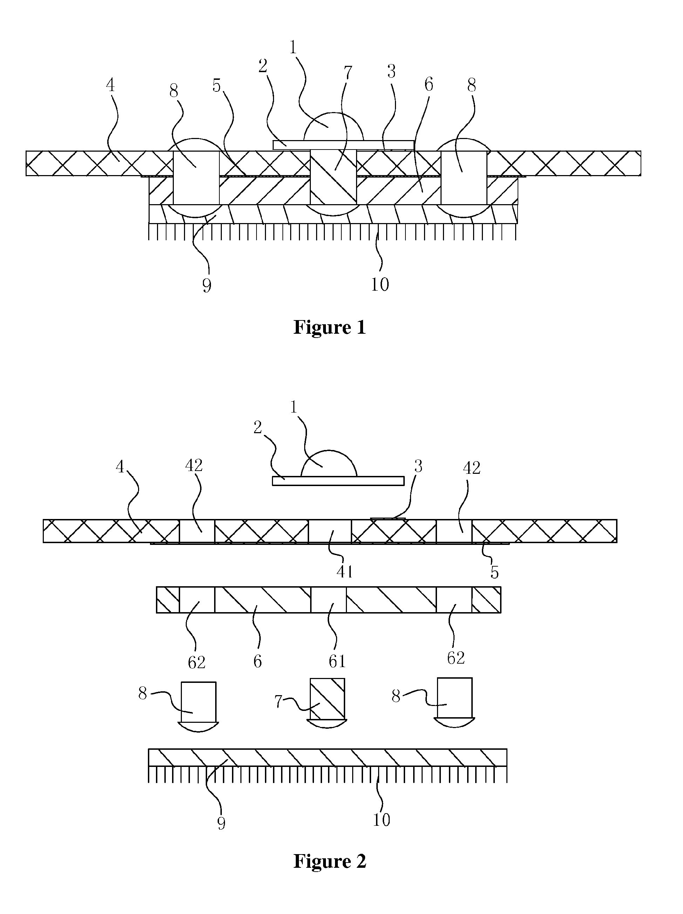

FIGs. 1-2 schematically show an overall view and an exploded view of the heat dissipating structure manufactured in the invention, respectively.

The manufacturing process of a high-power LED radiating structure of the invention includes Steps (1)-(7) below.

At Step (1), parts or materials such as a PCB board 4, a heat conducting plate 6 and a heat dissipating plate 9 are prepared, where the heat conducting plate 6 may be made from copper, aluminum and the like, the heat conducting pole 8 may be made from copper, the heat dissipating plate 9 may be made from aluminum or copper. Due to the good heat conducting and dissipating function of the materials such as copper and aluminum, the achievement of the objective of the invention may be facilitated in the case that the heat conducting plate 6 and heat dissipating plate 9 are made from copper and aluminum. Of course, the aforementioned structural parts may also be made from other metal material with good heat conducting and dissipating property. The heat conducting pole 8 and the heat conducting plate 6 may be made integrally, or may be separate and welded fixedly.

At Step (2), a first locating hole 41 and a first fixing hole 42 passing through both sides of the PCB board 4 are arranged in the PCB board 4, a copper plate layer 5 is welded on one side of the PCB board 4, soldering paste is applied to the surface of the copper plate layer 5 for the purpose of fixing the heat conducting plate 6 via welding, and an electrode weld pad 3 is welded on the other side of the PCB board 4 in order for connecting the electrode part on the bottom side of the substrate 2 of the LED 1.

At Step (3), a second locating hole 61 and a second fixing hole 62 passing through both sides of the heat conducting plate 6 are provided in the heat conducting plate 6.

It shall be noted that, in order to improve the stability of the inventive structure, there may be a plurality of the first fixing holes 42 distributed evenly around the first locating hole 41; likewise, there may be a plurality of the second fixing holes 62 distributed evenly around the second locating hole 61.In the case of multiple first fixing holes 42 and multiple second fixing holes 62, the first fixing holes 42 match the second fixing holes 62 in a one-to-one correspondence relationship in terms of position and number.

At Step (4), a side of the heat conducting plate 6 is stacked on the side of the PCB board on which the copper plate layer 5 is provided, the first locating hole 41 and the second locating hole 61 map with each other, the first fixing hole 42 and the second fixing hole 62 map with each other, and a fixing pole 8 is inserted into the first fixing hole 42 and the second fixing hole 62 to fixedly connect the PCB board 4 and the heat conducting plate 6 together. Here, when both of the first fixing hole 42 and the second fixing hole 62 are provided as through holes, the fixing pole 8 may be a rivet, so that the heat conducting plate 6 and the PCB board 4 may be connected by riveting, and the rivet is stamped by a stamping equipment after the riveting; and when both of the first fixing hole 42 and the second fixing hole 62 are provided as threaded holes, the fixing pole 8 may be a screw, so that the heat conducting plate 6 and the PCB board 4 are threadedly connected.

Additionally, the heat conducting plate 6 and the copper plate layer 5 may be connected by welding if the heat conducting plate 6 is made from copper, and connected by the screw if the heat conducting plate 6 is made from aluminum, to further improve the structural firmness and the structural compactibility.

At Step (5), the heat conducting pole 7 is inserted into the first locating hole 41 and the second locating hole 61, and one end of the heat conducting pole 7 protrudes out of the side of the PCB board 4 by a length (i.e. the length of the protruding end) larger than or equal to the thickness of the electrode weld pad 3; the shape and size of the heat conducting pole 7 match the shape and size of any of the first locating hole 41 and the second locating hole 61, in particular, the cross section of the heat conducting pole 7 may be of a circular, oval, triangle or hexagonal shape; when the shape of the cross section of the heat conducting pole 7 is circular, the inner walls of the locating holes 41 and 61 may be provided with inner screw threads, and the outer wall of the heat conducting pole 7 may be provided with outer screw threads, so that the heat conducting pole 7 is threadedly connected with the first and second locating holes 41 and 61. The threaded connection between the heat conducting pole 7 and the first and second locating holes 41 and 61 may improve the compactibility of the inventive structure, and in turn improve the conducting and dissipating function of the structure.

At Step (6), the assembled heat conducting plate 6 and the PCB board 4 obtained in Step (5) is placed on the stamping equipment, which stamps on the upper end face of the heat conducting pole 7, and the length of the protruding end of the heat conducting pole 7 may be adjusted by modulating a sliding block of the stamping equipment, so that the upper end face of the heat conducting pole 7 is at the same plane with the upper surface of the electrode weld pad. This Step (6) is essential for the manufacturing process of the invention. As mentioned above, one end of the heat conducting pole 7 protrudes out of the side face of the PCB board 4, with the length of the protruding end of the heat conducting pole 7 being larger than or equal to the thickness of the electrode weld pad 3; when the length of the protruding end of the heat conducting pole 7 is equal to the thickness of the electrode weld pad 3, the stamping equipment can be used to adjust the upper end face of the heat conducting pole 7 effectively, to ensure that the upper end face of the heat conducting pole 7 is at the same plane with the upper surface of the electrode weld pad 3; and when the length of the protruding end of the heat conducting pole 7 is larger than the thickness of the electrode weld pad 3, the sliding block of the stamping equipment is adjusted and the stamping equipment is used to stamp the heat conducting pole 7, and hence both the height and the upper end face of the heat conducting pole 7 are adjusted effectively, so that the upper end face of the heat conducting pole 7 is at the same plane with the upper surface of the electrode weld pad 3. As such, the bottom side of the substrate 2 is sufficiently engaged with both the upper end face of the heat conducting pole 7 and the upper surface of the electrode weld pad 3. That is, the electrode part at the bottom side of the substrate 2 is sufficiently in contact and welded with the electrode weld pad 3, at the same time, the heat conducting part at the bottom side of the substrate 2 is sufficiently in contact and welded with the upper end face of the heat conducting pole 7, thereby increasing the contact area between the heat conducting part at the bottom side of the substrate 2 and the upper end face of the heat conducting pole 7, to ensure that the heat generated by the LED 1 can be rapidly conducted to the heat dissipating plate 9 in time via the heat conducting pole 7 and the heat conducting plate 6, and then dissipated by the heat dissipating plate 9.

At Step (7), the upper side of the heat dissipating plate 9 is engaged with the other side of the heat dissipating plate 6, so that the heat dissipating plate 9 may be used for rapid heat dissipating from the conducting plate 6. Several heat dissipating fins 10 are provided on the lower side of the heat dissipating plate 9 to increase the heat dissipating area of the heat dissipating plate 9, and hence to enhance the heat dissipating effect of the heat dissipating plate 9.

The heat dissipating structure manufactured in the invention can quickly dissipate the heat produced by the LED, and its heat conducting and dissipating effects are greatly enhanced compared with that in the prior art.

**Table 1: Temperature data measurements of the existing heat dissipating structure (former) and the inventive heat dissipating structure (new).**

| | Input current | Ambient temperature | Heat sink temperature (former) | Aluminum substrate (former) | Heat dissipating plate |
|---|---|---|---|---|---|
| | | | Heat conducting pole temperature (new) | Heat conducting plate (new) | |
| Heat dissipating structure (former) | 700mA | 24.3°C | 57.3°C | 44.7 °C | 45.2°C |
| Heat dissipating structure (new) | 700mA | 28 °C | 48.1/51°C | 47.3/50.3 °C | 45.6/50.3°C |

As can be seen, in the case that the high-power LEDs respectively provided with the new inventive heat dissipating structure and the former heat dissipating structure are provided with the same current, and the ambient temperature of the new heat dissipating structure is higher, the temperature of the heat conducting pole in the new heat dissipating structure is notably lower than the temperature of the heat sink of the former heat dissipating structure, but the temperature of the heat conducting plate and the heat dissipating plate in the new heat dissipating structure are notably higher than the temperature of the aluminum substrate and the heat dissipating plate of the former heat dissipating structure, this fully illustrates that the heat dissipating effect of the new heat dissipating structure made by the inventive manufacturing process is better than that of the former heat dissipating structure.

The above description discloses only preferred embodiments of the invention, and any equivalent changes and modifications made on the construction, characteristics, and principles of the scope of the invention fall within the scope of the invention.

## Claims

1. A manufacturing process of a high-power LED heat dissipating structure, comprising steps of:
1) preparing a PCB board (4), a heat conducting plate (6) and a heat dissipating plate (9);
2) providing in the PCB board (4) a first locating hole (41) and a first fixing hole (42) that pass through both sides of the PCB board (4), welding a copper plate layer (5) on one side of the PCB board (4), and welding an electrode weld pad (3) on the other side of the PCB board (4), and then applying soldering paste on a surface of the copper plate layer (5);
3) providing in the heat conducting plate (6) a second locating hole (61) and a second fixing hole (62) that pass through both sides of the heat conducting plate (6);
4) stacking a side of the heat conducting plate (6) on a side of the PCB board (4) on which the copper plate layer (5) is provided, wherein the first locating hole (41) and the second locating hole (62) map with each other, and the first fixing hole (42) and the second fixing hole (62) map with each other; and inserting a fixing pole (8) into the first fixing hole (42) and the second fixing hole (42) to fixedly connect the PCB board (4) and the heat conducting plate (6) together;
5) inserting a heat conducting pole (7) into the first locating hole (41) and the second locating hole (61), wherein one end of the heat conducting pole (7) protrudes out of a side of the PCB board (4), and the length of the protruding end of the heat conducting pole (7) is larger than or equal to the thickness of the electrode weld pad (3);
6) placing the heat conducting plate (6) and the PCB board (4), into which the heat conducting pole (7) is inserted in Step 5), on a stamping equipment, which stamps on an upper end face of the heat conducting pole (7) by fixing a lower end face of the heat conducting pole (7), to achieve the length of the protruding end of the heat conducting pole (7) by adjusting a sliding block of the stamping equipment, so that the upper end face of the heat conducting pole (7) is at the same plane with the upper surface of the electrode weld pad (3); and
7) fixedly engaging the upper side of the heat dissipating plate (9) with the other side of the heat conducting plate (6).

2. The process of claim 1, wherein, several heat dissipating fins (10) are provided on the lower side of the heat dissipating plate (9) in Step 5).

3. The process of claim 1, wherein in Step 4), after the PCB board (4) and the heat conducting plate (6) are fixedly connected together, the heat conducting plate (6) and the copper plate layer (5) are welded together through reflow soldering.

4. The process of claim 1, wherein in Step 4), the first fixing hole (42) and the second fixing hole (62) are provided as through holes, and the fixing pole (8) is a rivet.

5. The process of claim 1, wherein in Step 4), the first fixing hole (42) and the second fixing hole (62) are provided as threaded holes, and the fixing pole is a screw.

6. The process of claim 1, wherein in Step 1), the heat conducting pole (7) is threadedly connected with the first locating hole (41) and the second locating hole (61).

7. The process of claim 1, wherein in Step 1), the heat conducting plate (6) is made from copper.

8. The process of claim 1, wherein in Step 1), the heat dissipating plate (9) is made from aluminum or copper.

9. The process of claim 1, wherein in Step 1), the heat conducting pole (8) is made from copper.
